# EUROPÄISCHE PATENTANMELDUNG

(11) **EP 4 822 300 A1**
(43) Veröffentlichungstag der Anmeldung: **14.10.2026**
(21) Anmeldenummer: 26163537.9
(22) Anmeldetag: 10.03.2026
(51) Int. Cl.: G01D 3/08, G01L 9/04, G01L 27/00, G01R 31/28

(54) **SENSORSYSTEM UND VERFAHREN ZUR ÜBERPRÜFUNG EINER SICHERHEITSINTEGRITÄT EINES SENSORSYSTEMS**

(30) Priorität: 08.04.2025 DE 102025113847
(71) Anmelder: Pilz GmbH & Co. KG, 73760 Ostfildern (DE)
(72) Erfinder: Monnee, Lambertus Pieter, 73760 Ostfildern (DE); Glaser, Armin, 73760 Ostfildern (DE)
(74) Vertreter: Manske, Jörg

(57) **Zusammenfassung**

Die Erfindung betrifft ein Sensorsystem (1), mit zwei Analogsensoren (2, 3), die jeweils ein resistives Sensormittel (20, 30) zur Messung einer physikalischen Größe und eine Wheatstone-Brücke (21, 31) umfassen. Jeder Analogsensor (2, 3) erzeugt ein analoges Spannungssignal (4, 5) als Messsignal. Die Sensormittel (20, 30) sind an Schaltpfade (24, 34) angeschlossen, die jeweils einen Arbeitspfad (25, 35) und einen parallel dazu geschalteten Testpfad (26, 36) mit veränderten Widerstandseigenschaften enthalten. Eine Sicherheitssteuerung (8) ist mit den Analogsensoren (2, 3) verbunden und dazu ausgebildet,
(a) die Messsignale beider Sensoren zu empfangen und auszuwerten,
(b) zum Testen des ersten Sensormittels den zugehörigen Testpfad (26) zu aktivieren, ein erstes Testsignal (T1) zu erzeugen und den Signalhub des ersten Messsignals zu erfassen,
(c) zum Testen des zweiten Sensormittels den zugehörigen Testpfad (36) zu aktivieren, ein zweites Testsignal (T2) zu erzeugen und den Signalhub des zweiten Messsignals zu erfassen, sowie
(d) den Signalhub der Messsignale beider Analogsensoren (2, 3) zu plausibilisieren.

## Beschreibung

Die vorliegende Erfindung betrifft ein Sensorsystem mit mindestens zwei Analogsensoren sowie ein Verfahren zur Überprüfung einer Sicherheitsintegrität eines Sensorsystems.

Sensorsysteme mit Analogsensoren werden häufig in prozessnahen Bereichen eingesetzt, um beispielsweise Drücke, Temperaturen oder Leckagen zu erfassen. Aus Gründen der Messredundanz weisen derartige Sensorsysteme insbesondere in sicherheitskritischen Anwendungen zumindest zwei einkanalige Analogsensoren auf.

Ein mögliches Anwendungsgebiet für Sensorsysteme mit Analogsensoren ist die Wasserstofftechnologie, die in den letzten Jahren zunehmend an Bedeutung gewonnen hat. So ist es unter dem Gesichtspunkt der funktionalen Sicherheit erforderlich, die bei der Wasserstoffgewinnung, beim Wasserstofftransport und bei der Wasserstofflagerung herrschenden Drücke und mögliche Leckagen in den eingesetzten Wasserstofftanks, Leitungssystemen und anderen fluidführenden beziehungsweise fluidverteilenden Einrichtungen zu erfassen. Entsprechendes gilt auch für Tankstationen, in denen Brennstoffzellen-Fahrzeuge mit Wasserstoff betankt werden.

Die zur Druckmessung eingesetzten Analogsensoren basieren auf einem Messprinzip, bei dem zumindest ein resistives analoges Sensormittel, insbesondere ein Dehnungsmessstreifen, zur Erfassung von Drücken oder auch Druckänderungen zum Einsatz kommt. Ein Dehnungsmessstreifen ist auf Dehnung und Stauchung empfindlich und ändert dadurch seinen elektrischen Widerstand. Das resistive analoge Sensormittel, insbesondere der Dehnungsmessstreifen, wandelt dabei die physikalische Messgröße "Druck" in ein sich proportional hierzu veränderliches elektrisches Signal um. Ein Analogsensor zur Erfassung eines Drucks umfasst zusätzlich zu dem resistiven Sensormittel typischerweise einen druckstabilen Grundkörper und eine dünne Membran, an der das resistive Sensormittel, insbesondere der Dehnungsmessstreifen, angebracht ist. Unter der Einwirkung eines Drucks verformt sich die Membran reversibel. Dadurch wird das resistive analoge Sensormittel, insbesondere der Dehnungsmessstreifen, gedehnt beziehungsweise gestaucht, so dass sich der elektrische Widerstand ändert. Diese Widerstandsänderung ist direkt proportional zum Druck. Das resistive Sensormittel ist Teil einer Wheatstone-Messbrücke, dessen elektrisches Signal abgegriffen und ausgewertet werden kann. Ein Problem derartiger Sensorsysteme besteht darin, dass diese nichtsichere Analogsensoren verwenden.

Die Aufgabe der Erfindung besteht darin, ein Sensorsystem mit zumindest zwei Analogsensoren und ein Verfahren zur Überprüfung einer Sicherheitsintegrität eines derartigen Sensorsystems zur Verfügung zu stellen, die eine sichere Auswertung der nicht-sicheren Analogsensoren ermöglichen.

Die Lösung dieser Aufgabe liefern ein Sensorsystem mit den Merkmalen des Anspruchs 1 sowie ein Verfahren zur Überprüfung einer Sicherheitsintegrität eines Sensorsystems mit den Merkmalen des Anspruchs 10. Die Unteransprüche betreffen vorteilhafte Weiterbildungen der Erfindung.

Ein erfindungsgemäßes Sensorsystem umfasst:
- einen ersten Analogsensor mit zumindest einem ersten resistiven Sensormittel, welches zur Messung einer physikalischen Größe eingerichtet ist, und mit einer ersten Wheatstone-Brücke, welche das erste Sensormittel umfasst und dazu ausgebildet ist, ein erstes analoges Spannungssignal zu erzeugen, welches ein Messsignal des ersten Analogsensors bildet oder aus dem das Messsignal des ersten Analogsensors durch eine Messsignalwandlung erzeugbar ist, wobei das erste Sensormittel an einen ersten Schaltpfad angeschlossen ist, der einen Arbeitspfad und einen Testpfad umfasst, der parallel zum Arbeitspfad geschaltet ist und gegenüber dem Arbeitspfad veränderte Widerstandseigenschaften aufweist,
- einen zweiten Analogsensor mit zumindest einem zweiten resistiven Sensormittel, welches zur Messung einer physikalischen Größe eingerichtet ist, und mit einer zweiten Wheatstone-Brücke, welche das zweite Sensormittel umfasst und dazu ausgebildet ist, ein zweites analoges Spannungssignal zu erzeugen, welches ein Messsignal des zweiten Analogsensors bildet oder aus dem das Messsignal des zweiten Analogsensors durch eine Messsignalwandlung erzeugbar ist, wobei das zweite Sensormittel an einen zweiten Schaltpfad angeschlossen ist, der einen Arbeitspfad und einen Testpfad umfasst, der parallel zum Arbeitspfad geschaltet ist und gegenüber dem Arbeitspfad veränderte Widerstandseigenschaften aufweist,
- eine Sicherheitssteuerung, die an die Analogsensoren angeschlossen ist, wobei die Sicherheitssteuerung dazu ausgebildet ist,
   a) die Messsignale des ersten Analogsensors und des zweiten Analogsensors zu empfangen und auszuwerten,
   b) zum Testen des ersten Sensormittels den Testpfad des ersten Schaltpfads zu aktivieren, ein erstes Testsignal zu erzeugen und einen Signalhub des Messsignals des ersten Analogsensors zu erfassen,
   c) zum Testen des zweiten Sensormittels den Testpfad des zweiten Schaltpfads zu aktivieren, ein zweites Testsignal zu erzeugen und einen Signalhub des Messsignals des zweiten Analogsensors zu erfassen, und
   d) den Signalhub der Messsignale der Analogsensoren zu plausibilisieren.

Das erfindungsgemäße Sensorsystem ermöglicht durch das Testen der Sensormittel in vorteilhafter Weise eine sichere Auswertung nicht-sicherer Analogsensoren und kann in ganz unterschiedlichen prozessnahen Bereichen eingesetzt werden, um beispielsweise Drücke, Temperaturen oder Leckagen zu erfassen. Das Testsignal ist vorzugsweise so gewählt, dass es einen High-Pegel (zum Beispiel + 24 V) und einen Low-Pegel (zum Beispiel 0 V) aufweist. Während der Durchführung des Tests eines der beiden Analogsensoren wird die Wheatstone-Brücke des betreffenden Analogsensors verstimmt. Dieses hat zur Folge, dass ein erhöhter beziehungsweise verringerter Signalhub in demjenigen Zeitintervall erzeugt wird, in dem das betreffende Testsignal einen High-Pegel aufweist. Wenn in dem zu überwachenden System die zu messende physikalische Größe einen bestimmten Zahlenwert hat, gibt jeder der beiden Analogsensoren während des Normalbetriebs, in dem kein Test stattfindet, ein bestimmtes analoges Messsignal aus, welches mit diesem Zahlenwert korrespondiert. Bei der Durchführung des Tests der Sensormittel kommt es aufgrund unterschiedlicher Widerstände in den Testpfaden der Sensormittel zu einer Widerstandserhöhung beziehungsweise zu einer Widerstandsverringerung, aus denen im Vergleich zum Normalbetrieb ein negativer Signalhub beziehungsweise ein positiver Signalhub resultiert. Die Größe des Signalhubs hängt dabei von den in den Schaltpfaden verwendeten Widerständen ab. Die entsprechenden Signalhübe können entsprechend aus den Messsignalen herausgerechnet werden. Die Erwartungshaltung der Sicherheitssteuerung ist, dass sich die analogen Messsignale, bei denen es sich insbesondere um Stromsignale oder Spannungssignale handelt, während der Durchführung des Tests des betreffenden Analogsensors in einem definierten Zeitintervall um einen definierten Wert ändern müssen. Dadurch können die analogen Messsignale der Analogsensoren auf ihre Plausibilität hin überprüft werden, so dass auch eine Prüfung der Sicherheitsintegrität der Analogsensoren möglich ist. Mit anderen Worten ermöglicht das erfindungsgemäße Sensorsystem eine sichere Auswertung der nicht-sicheren Analogsensoren. Die Sicherheitssteuerung ist vorzugsweise dazu ausgebildet, sicherheitsgerichtete Funktionen in dem zu überwachwachenden System zu initiieren, wenn die Plausibilitätsprüfung ergibt, dass die Sicherheitsintegrität der Analogsensoren nicht mehr gegeben ist.

In einer Ausführungsform wird vorgeschlagen, dass die Sicherheitssteuerung dazu ausgebildet ist, während des Tests des ersten Sensormittels den Arbeitspfad des ersten Schaltpfads zu deaktivieren. Das Testsignal für den ersten Analogsensor passiert somit nur den Testpfad des ersten Schaltpfads. Der Arbeitspfad ist in einem elektrisch sperrenden Zustand.

In einer Ausführungsform ist vorgesehen, dass die Sicherheitssteuerung dazu ausgebildet ist, während des Tests des zweiten Sensormittels den Arbeitspfad des zweiten Schaltpfads zu deaktivieren. Das Testsignal für den zweiten Analogsensor passiert somit nur den Testpfad des zweiten Schaltpfads. Der Arbeitspfad ist in einem elektrisch sperrenden Zustand.

In einer Ausführungsform besteht die Möglichkeit, dass der Arbeitspfad des ersten Sensormittels einen Öffnerkontakt und der Testpfad einen Schließerkontakt und einen elektrisch in Reihe dazu geschalteten Widerstand umfasst, so dass der Arbeitspfad und der Testpfad für das erste Sensormittel unterschiedliche Widerstandseigenschaften aufweisen.

In einer Ausführungsform wird vorgeschlagen, dass der Arbeitspfad des zweiten Sensormittels einen Öffnerkontakt und einen elektrisch in Reihe dazu geschalteten Widerstand umfasst und der Testpfad einen Schließerkontakt umfasst, so dass der Arbeitspfad und der Testpfad für das zweite Sensormittel unterschiedliche Widerstandseigenschaften aufweisen.

In einer vorteilhaften Ausführungsform ist vorgesehen, dass die Sicherheitssteuerung dazu ausgebildet ist, den ersten Analogsensor und den zweiten Analogsensor zeitlich alternierend zu testen. Diese zeitlich alternierend durchgeführten Tests haben den Vorteil, dass insbesondere Kabelfehler, Querschlüsse, Fremdspannungseinspeisungen, Schlüsse gegenüber Signalmasse erfasst werden können. Es besteht in einer Ausführungsform die Möglichkeit, dass die Tests der beiden Analogsensoren kontinuierlich durchgeführt werden. Darunter soll verstanden werden, dass die Analogsensoren während des Betriebs des Sensorsystems fortlaufend abwechselnd getestet werden. Während also der eine der beiden Analogsensoren getestet wird, misst jeweils der andere der beiden Analogsensoren die zu messende physikalische Messgröße, wie zum Beispiel den Druck.

Vorzugsweise kann die Sicherheitssteuerung dazu ausgebildet sein, die Testsignale als Rechteckpulse zu erzeugen. Dadurch kann insbesondere ein zeitlich alternierender Test der beiden Analogsensoren mit High-Pegeln und Low-Pegeln technisch sehr einfach realisiert werden.

In einer Ausführungsform besteht die Möglichkeit, dass die Sicherheitssteuerung eine erste kombinierte Signalverarbeitungs- und Testsignalerzeugungseinrichtung, die dem ersten Analogsensor zugeordnet ist, und/oder dass die Sicherheitssteuerung eine zweite kombinierte Signalverarbeitungs- und Testsignalerzeugungseinrichtung, die dem zweiten Analogsensor zugeordnet ist, umfasst.

Um eine Unterscheidung zwischen tatsächlichen Änderungen der physikalischen Messgröße, insbesondere Druckänderungen, innerhalb des zu überwachenden Systems, die zu Widerstandsänderungen der Sensormittel führen, und einem Signalhub aufgrund einer gemeinsamen Fehlerursache (so genannter Common Cause Fehler), bei der es sich beispielsweise um elektromagnetische Störungen oder Störungen durch einen Widerstandstemperaturdrift handeln kann, zu ermöglichen, ist in einer vorteilhaften Ausführungsform vorgesehen, dass die Analogsensoren derart ausgebildet sind, dass sie die Messsignale unterschiedlich stark verstärken. Unterschiedliche Verstärkungen können in vorteilhafter Weise zum Beispiel durch unterschiedliche k-Faktoren der beiden Wheatstone-Brücken realisiert sein. Unter einem k-Faktor wird eine Proportionalitätsgröße verstanden, welche den Zusammenhang zwischen der gemessenen mechanischen Verformung und der relativen Verformung des betreffenden Sensormittels repräsentiert. Dieses bedeutet mit anderen Worten, dass das Ausgangssignal der Wheatstone-Brücken, aus dem das Messsignal des Analogsensors resultiert, umso stärker ist, desto größer der k-Faktor ist. Daraus ergibt sich, dass die Auswirkung auf den erfassbaren Signalhub für beide Analogsensoren und damit in beiden Kanälen des Sensorsystems unterschiedlich ist und damit von der Sicherheitssteuerung detektierbar ist. Ist die Abweichung bei beiden Analogsensoren gleich, liegt eine Prozesswertänderung, beispielsweise eine Druckänderung, vor. Werden unterschiedliche Änderungen erfasst, liegt demgegenüber ein Fehlerfall vor.

Bei einem erfindungsgemäßen Verfahren zur Überprüfung einer Sicherheitsintegrität eines Sensorsystems nach einem der Ansprüche 1 bis 9 ist vorgesehen, dass
- zum Testen des ersten Sensormittels der Testpfad des ersten Schaltpfads geschlossen wird, das erste Testsignal erzeugt wird und ein daraus resultierender Signalhub des Messsignals des ersten Analogsensors erfasst wird,
- zum Testen des zweiten Sensormittels der Testpfad des zweiten Schaltpfads geschlossen wird, das zweite Testsignal erzeugt wird und ein daraus resultierender Signalhub des Messsignals des zweiten Analogsensors erfasst wird, und
- der Signalhub des Messsignals des ersten Analogsensors und der Signalhub des Messsignals des zweiten Analogsensors von der Sicherheitssteuerung plausibilisiert werden.

Das erfindungsgemäße Verfahren ermöglicht in vorteilhafter Weise eine sichere Auswertung nicht-sicherer Analogsensoren und dadurch die Überprüfung der Sicherheitsintegrität eines Sensorsystems, so dass im Fehlerfall entsprechende Sicherheitsmaßnahmen ergriffen werden können.

In einer vorteilhaften Ausführungsform ist vorgesehen, dass der erste Analogsensor und der zweite Analogsensor zeitlich alternierend getestet werden. Dadurch wird in vorteilhafter Weise erreicht, dass zum Beispiel Kabelfehler, Querschlüsse, Fremdspannungseinspeisungen, Schlüsse gegenüber Signalmasse zuverlässig erfasst werden können.

Weitere Merkmale und Vorteile eines Ausführungsbeispiels der Erfindung werden unter Bezugnahme auf die Zeichnungen nachfolgend beschrieben. Es zeigen:
- Fig. 1: eine schematische Darstellung, die das grundlegende Funktionsprinzip eines Sensorsystems und eines Verfahrens zur Überprüfung der Sicherheitsintegrität des Sensorsystems veranschaulicht,
- Fig. 2: eine schematische Darstellung eines ersten Sensormittels des Sensorsystems mit einem zugehörigen Testschaltpfad, der bei einem Verfahren zur Überprüfung der Sicherheitsintegrität des Sensorsystems gemäß der vorliegenden Erfindung aktivierbar ist,
- Fig. 3: eine schematische Darstellung eines zweiten Sensormittels des Sensorsystems mit einem zugehörigen Testschaltpfad, der bei dem Verfahren zur Überprüfung der Sicherheitsintegrität des Sensorsystems aktivierbar ist,
- Fig. 4: einen beispielhaften Testsignalverlauf für die Überprüfung der Sicherheitsintegrität der Analogsensoren des Sensorsystems.

Es ist nicht notwendig, dass ein erfindungsgemäßes Sensorsystem 1 alle nachfolgend beschriebenen Merkmale aufweist. Es ist auch möglich, dass ein erfindungsgemäßes Sensorsystem 1 nur einzelne Merkmale des nachfolgend beschriebenen Ausführungsbeispiels aufweist.

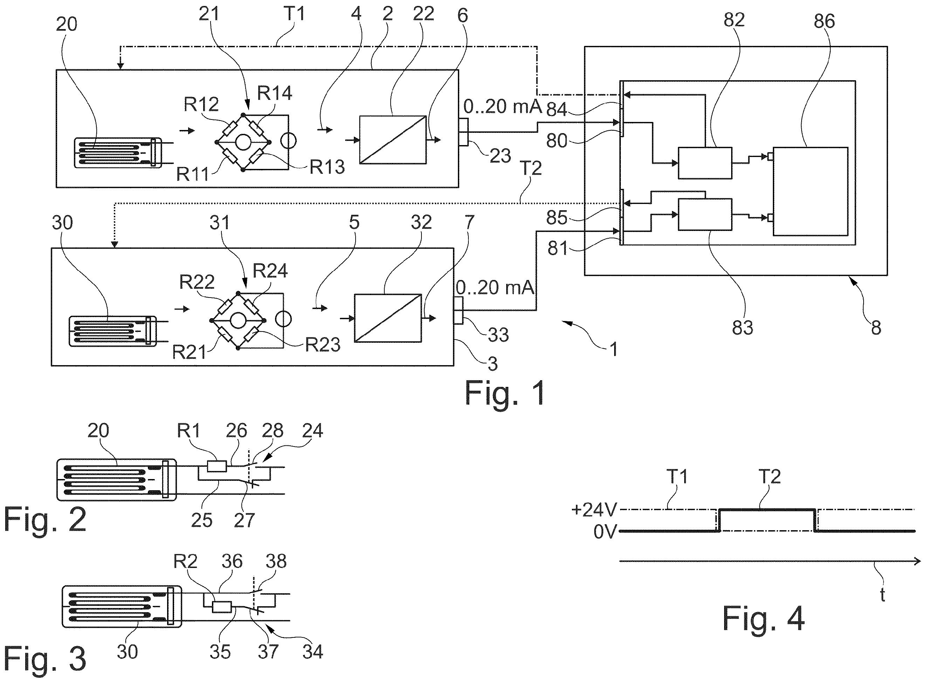

Unter Bezugnahme auf Fig. 1 umfasst das Sensorsystem 1 einen ersten Analogsensor 2 und einen zweiten Analogsensor 3, die jeweils einkanalig ausgebildet sind. Der erste Analogsensor 2 umfasst ein erstes resistives Sensormittel 20, welches zur Messung einer physikalischen Größe eingerichtet ist und einen veränderbaren elektrischen Widerstand aufweist. Der zweite Analogsensor 3 umfasst ein zweites resistives Sensormittel 30, welches zur Messung derselben physikalischen Größe eingerichtet ist und einen veränderbaren elektrischen Widerstand aufweist. Dadurch, dass zwei Analogsensoren 2, 3 vorgesehen sind, ergibt sich eine entsprechende Redundanz, die insbesondere bei sicherheitskritischen Anwendungen vorteilhaft ist beziehungsweise zwingend erforderlich sein kann.

Das Sensorsystem 1 mit den beiden Analogsensoren 2, 3 kann in unterschiedlichen prozessnahen Bereichen eingesetzt werden, um beispielsweise Drücke, Temperaturen oder Leckagen zu erfassen. Zur weiteren Erläuterung des grundlegenden Funktionsprinzips des Sensorsystems 1 soll nachfolgend angenommen werden, dass die beiden Sensormittel 20, 30 dazu eingerichtet sind, Drücke beziehungsweise Druckänderungen in einem zu überwachenden System zu messen. Das Sensorsystem 1 eignet sich beispielsweise für Prozessanwendungen wie die Wasserstofferzeugung, die Wasserstoffspeicherung sowie den Betrieb von Wasserstoff-Betankungseinrichtungen für Fahrzeuge. Bei diesen Anwendungen müssen die herrschenden Drücke beziehungsweise Druckänderungen überwacht werden, so dass im Falle auftretender Gefahrensituationen geeignete Sicherheitsmaßnahmen ergriffen werden können, um eine Gefährdung von Menschen und der Umgebung zu verhindern.

Die bei dem hier vorgestellten Sensorsystem 1 eingesetzten Sensormittel 20, 30 sind zu diesem vorstehend genannten Zweck vorzugsweise als Dehnungsmessstreifen ausgebildet. Derartige Dehnungsmessstreifen zeichnen sich dadurch aus, dass sie ihren elektrischen Widerstand bei mechanischen Verformungen, die durch Dehnungen oder Stauchungen hervorgerufen werden, ändern. Die zur Druckmessung vorgesehenen Analogsensoren 2, 3 umfassen typischerweise einen druckstabilen Grundkörper und eine dünne Membran, die in Fig. 1 aus Vereinfachungsgründen allerdings nicht dargestellt wurden. Die Membran ist mit den als Dehnungsmessstreifen ausgeführten Sensormitteln 20, 30 versehen, die auf Dehnung und Stauchung empfindlich sind. Aufgrund der Einwirkung eines Drucks verformt sich die Membran reversibel. Dadurch werden die auf ihr aufgebrachten, als Dehnungsmessstreifen ausgebildeten Sensormittel 20, 30 gedehnt beziehungsweise gestaucht, so dass sich ihr elektrischer Widerstand ändert.

Um die druckabhängigen Widerstandsänderungen der als Dehnungsmessstreifen ausgeführten Sensormittel 20, 30 bei druckabhängigen mechanischen Verformungen messtechnisch erfassen zu können, weisen die beiden Analogsensoren 2, 3 jeweils eine Wheatstone-Brücke 21, 31 auf, die in an sich bekannter Weise mit einer Brückenspeisespannung betrieben werden.

Der erste Analogsensor 2 weist eine erste Wheatstone-Brücke 21 auf, welche das als Dehnungsmessstreifen ausgebildete erste Sensormittel 20 des ersten Analogsensors 2 umfasst und dazu ausgebildet ist, als Ausgangssignal ein erstes analoges Spannungssignal 4, welches in Fig. 1 durch einen Pfeil angedeutet wurde, zu erzeugen. Die erste Wheatstone-Brücke 21 umfasst eine an sich bekannte Brückenschaltungsanordnung mit vier elektrischen Widerständen R11, R12, R13, R14, wobei einer dieser Widerstände R11, R12, R13, R14 durch den veränderlichen elektrischen Widerstand des vorliegend als Dehnungsmessstreifen ausgebildeten ersten Sensormittels 20 gebildet ist.

Der zweite Analogsensor 3 weist eine zweite Wheatstone-Brücke 31 auf, welche das zweite Sensormittel 30 des zweiten Analogsensors 3 umfasst und dazu ausgebildet ist, als Ausgangssignal ein zweites analoges Spannungssignal 5 zu erzeugen. Die zweite Wheatstone-Brücke 31 umfasst ebenfalls eine Brückenschaltungsanordnung mit vier elektrischen Widerständen R21, R22, R23, R24, wobei einer dieser Widerstände R21, R22, R23, R24 durch den veränderlichen elektrischen Widerstand des als Dehnungsmessstreifen ausgebildeten zweiten Sensormittels 30 gebildet ist.

Um zum Beispiel Drücke an unterschiedlichen Orten an der Membran oder an einem Ort der Membran in unterschiedlichen Raumrichtungen messen zu können, besteht prinzipiell die Möglichkeit, dass die Analogsensoren 2, 3 mehr als ein resistives Sensormittel 20, 30, umfassen, welche Teil der ersten Wheatstone-Brücke 21 des ersten Analogsensors 2 beziehungsweise Teil der zweiten Wheatstone-Brücke 31 des zweiten Analogsensors 3 sind. In diesem Zusammenhang sind Ausführungsformen mit zwei oder vier Sensormitteln, die in der betreffenden Wheatstone-Brücke 21, 31 verschaltet sind, denkbar.

Die beiden Analogsensoren 2, 3 weisen ferner einen Messsignal-Wandler 22, 32 auf, welcher dazu ausgebildet ist, die analogen Spannungssignale 4, 5 der Wheatstone-Brücken 21, 31 zu verstärken. Vorliegend sind die Messsignal-Wandler 22, 32 zudem dazu ausgebildet, die analogen Spannungssignale 4, 5 in analoge Stromsignale 6, 7 zu wandeln. Die analogen Stromsignale 6, 7 bilden somit in diesem Ausführungsbeispiel die eigentlichen analogen Messsignale der Analogsensoren 2, 3, die entsprechend weiterverarbeitet und ausgewertet werden können. Grundsätzlich können auch die analogen Spannungssignale 4, 5 der Wheatstone-Brücken 21, 31 - gegebenenfalls signalverstärkt - die Messsignale der Analogsensoren 2, 3 bilden.

Das Sensorsystem 1 umfasst ferner eine Sicherheitssteuerung 8 mit zwei Signaleingängen 80, 81. Ein erster Signaleingang 80 der Sicherheitssteuerung 8 ist an einen Signalausgang 23 des ersten Analogsensors 2 angeschlossen. Ein zweiter Signaleingang 81 der Sicherheitssteuerung 8 ist an einen Signalausgang 33 des zweiten Analogsensors 3 angeschlossen. Die Sicherheitssteuerung 8 umfasst in diesem Ausführungsbeispiel eine erste kombinierte Signalverarbeitungs- und Testsignalerzeugungseinrichtung 82, die dem ersten Analogsensor 2 zugeordnet ist, und eine zweite kombinierte Signalverarbeitungs- und Testsignalerzeugungseinrichtung 83, die dem zweiten Analogsensor 3 zugeordnet ist.

Die erste kombinierte Signalverarbeitungs- und Testsignalerzeugungseinrichtung 82 ist dazu ausgebildet, das analoge Stromsignal 6, welches das Messsignal des ersten Analogsensors 2 bildet, zu empfangen und zu verarbeiten und dabei insbesondere einen Signalhub, der während des Tests des ersten Sensormittels 20 erzeugt wird, zu erfassen. Die erste kombinierte Signalverarbeitungs- und Testsignalerzeugungseinrichtung 82 ist ferner dazu ausgebildet, ein erstes Testsignal T1 zum Testen des ersten Sensormittels 20 zu erzeugen. Die Sicherheitssteuerung 8 verfügt über einen ersten Ausgang 84, über den während der Durchführung des Tests das erste Testsignal T1 zum ersten Sensormittel 20 übertragen wird.

Die zweite kombinierte Signalverarbeitungs- und Testsignalerzeugungseinrichtung 83 ist dazu ausgebildet, das analoge Stromsignal 7, welches das Messsignal des zweiten Analogsensors 3 bildet, zu empfangen und zu verarbeiten und dabei insbesondere einen Signalhub, der während des Tests des zweiten Sensormittels 30 erzeugt wird, zu erfassen. Die zweite kombinierte Signalverarbeitungs- und Testsignalerzeugungseinrichtung 83 ist ferner dazu ausgebildet, ein zweites Testsignal T2 zum Testen des zweiten Sensormittels 30 zu erzeugen. Die Sicherheitssteuerung 8 verfügt über einen zweiten Ausgang 85, über den das zweite Testsignal T2 zum zweiten Sensormittel 30 übertragen wird.

In diesem Ausführungsbeispiel sind die Signalverarbeitungs- und Testsignalerzeugungsfunktionen in die erste kombinierte Signalverarbeitungs- und Testsignalerzeugungseinrichtung 82 und in die zweite kombinierte Signalverarbeitungs- und Testsignalerzeugungseinrichtung 83 integriert. Grundsätzlich ist es auch möglich, diese Funktionen in zwei Funktionskomponenten aufzuteilen und eine erste Signalverarbeitungseinrichtung sowie eine erste Testsignalerzeugungseinrichtung für den ersten Analogsensor 2 und eine zweite Signalverarbeitungseinrichtung sowie eine zweite Testsignalerzeugungseinrichtung für den zweiten Analogsensor 3 vorzusehen. Die kombinierten Signalverarbeitungs- und Testsignalerzeugungseinrichtungen 82, 83 erhöhen jedoch in vorteilhafter Weise den Integrationsgrad der Sicherheitssteuerung 8.

Ferner umfasst die Sicherheitssteuerung 8 eine Auswerteeinrichtung 86, die dazu ausgebildet ist, die von den beiden kombinierten Signalverarbeitungs- und Testsignalerzeugungseinrichtungen 82, 83 verarbeiteten analogen Stromsignale (analoge Messsignale) 6, 7 der Analogsensoren 2, 3 in der weiter unten noch näher erläuterten Weise sicher auszuwerten. Insbesondere ist die Auswerteeinrichtung 86 dazu ausgebildet, den Signalhub, der während des Tests der Sensormittel 20, 30 der beiden Analogsensormittel 2, 3 auftritt, auszuwerten und insbesondere auch zu plausibilisieren.

Nachfolgend sollen nähere Einzelheiten eines Verfahrens zur Überprüfung einer Sicherheitsintegrität des vorstehend erläuterten Sensorsystems 1 näher erläutert werden, bei dem die nicht-sicheren Sensormittel 20, 30 der beiden Analogsensoren 2, 3 mittels der beiden Testsignale T1, T2 getestet werden. Für die Durchführung des Verfahrens ist es erforderlich, dass die Sensormittel 20, 30 der beiden Analogsensoren 2, 3 jeweils an einen elektrischen Schaltpfad 24, 34 angeschlossen sind, wobei jeder der Schaltpfade 24, 34 einen Arbeitspfad 25, 35 und einen Testpfad 26, 36, die parallel zueinander geschaltet sind, aufweist. Fig. 2 zeigt den Schaltpfad 24 des ersten Sensormittels 20 des ersten Analogsensors 2 und in Fig. 3 ist der Schaltpfad 34 des zweiten Sensormittels 30 des zweiten Analogsensors 3 dargestellt.

Wie in Fig. 2 zu erkennen, weist der Arbeitspfad 25 des ersten Sensormittels 20 des ersten Analogsensors 2 einen Öffnerkontakt 27 auf, der während des Normalbetriebs des Sensormittels 20, in dem der Druck gemessen wird und kein Test der Sicherheitsintegrität durchgeführt wird, in einer geschlossenen Stellung ist und damit elektrisch leitend ist. Der Testpfad 26, der parallel zum Arbeitspfad 25 geschaltet ist, umfasst einen Widerstand R1 und einen elektrisch in Reihe dazu geschalteten Schließerkontakt 28, der während des Normalbetriebs des Sensormittels 20 in einer geöffneten Stellung und damit elektrisch sperrend ist. Eine Betätigung des Öffnerkontakts 27 und des Schließerkontakts 28, die von der Sicherheitssteuerung 8 ausgelöst wird, erfolgt simultan. Der Öffnerkontakt 27 und der Schließerkontakt 28 können zum Beispiel Komponenten eines Relais, insbesondere eines Halbleiterrelais, sein. Die Funktionen des Öffnerkontakts 27 und des Schließerkontakts 28 können auch durch andere elektronische Schaltelemente implementiert werden.

Aus Fig. 3 ergibt sich, dass der Arbeitspfad 35 des zweiten Sensormittels 30 des zweiten Analogsensors 3 einen Öffnerkontakt 37, der während des Normalbetriebs des Sensormittels 30, in dem der Druck gemessen wird und kein Test der Sicherheitsintegrität durchgeführt wird, in einer geschlossenen Stellung ist und damit elektrisch leitend ist, sowie einen Widerstand R2 umfasst, der elektrisch in Reihe zum Öffnerkontakt 37 geschaltet ist. Der Testpfad 36, der parallel zum Arbeitspfad 35 geschaltet ist, umfasst einen Schließerkontakt 38, der während des Normalbetriebs des Sensormittels 30 in einer geöffneten Stellung und damit elektrisch sperrend ist. Eine Betätigung des Öffnerkontakts 37 und des Schließerkontakts 38, die von der Sicherheitssteuerung 8 ausgelöst wird, erfolgt simultan. Der Öffnerkontakt 37 und der Schließerkontakt 38 können zum Beispiel Komponenten eines Relais, insbesondere eines Halbleiterrelais, sein. Die Funktionen des Öffnerkontakts 37 und des Schließerkontakts 38 können auch durch andere elektronische Schaltelemente implementiert werden.

Das hier vorgestellte Verfahren zur Überprüfung der Sicherheitsintegrität der beiden nicht-sicheren Analogsensoren 2, 3 basiert auf dem Prinzip einer Zwangsdynamisierung. Die beiden Analogsensoren 2, 3 werden jeweils zeitlich alternierend mittels des zugehörigen Testsignals T1, T2 getestet. Während der Durchführung des Tests werden die Schaltelemente, das heißt die Öffnerkontakte 27, 37 und Schließerkontakte 28, 38, in den Schaltpfaden 24, 34 der beiden Analogsensoren 2, 3 von der Sicherheitssteuerung 8 derart angesteuert, dass die jeweiligen Öffnerkontakte 27, 37 innerhalb des Arbeitspfads 25, 35 geöffnet werden, so dass sie nachfolgend elektrisch sperrend sind, und gleichzeitig die Schließerkontakte 28, 38 des Testpfads 26, 36 geschlossen werden, so dass sie nachfolgend elektrisch leitend sind.

Bei den Testsignalen T1, T2 handelt es sich vorliegend um gepulste Rechtecksignale, deren Verläufe in Abhängigkeit von der Zeit t in Fig. 4 exemplarisch dargestellt sind. Die gepulsten, rechteckigen Testsignale T1, T2 weisen einen High-Pegel (vorliegend: + 24 V) sowie einen Low-Pegel (vorliegend: 0 V) auf. In diesem Ausführungsbeispiel sind die Pulsweiten der beiden Testsignale T1, T2 identisch. Ferner entsprechen die Längen der Pulspausen in diesem Ausführungsbeispiel auch den Pulsweiten. Es sind auch Ausführungsbeispiele denkbar, bei denen die Pulsweiten der beiden Testsignale T1, T2 unterschiedlich gewählt sind und/oder bei denen die Längen der Pulspausen und die Pulsweiten unterschiedlich gewählt sind.

Aufgrund des Widerstands R1 im Testpfad 26 für das erste Sensormittel 20 ergibt sich während der Durchführung des Tests im Vergleich zum Normalbetrieb, in der der Stromfluss durch den Arbeitspfad 25 erfolgt, eine Widerstandserhöhung.

Aufgrund des Widerstands R2 im Arbeitspfad 35 und des Nichtvorhandenseins eines Widerstands im Testpfad 36 für das zweite Sensormittel 30 ergibt sich im Vergleich zum Normalbetrieb während der Durchführung des Tests eine Widerstandsreduzierung.

Während der Testphase wird die Wheatstone-Brücke 21, 31 des betreffenden Analogsensors 2, 3 verstimmt. Dieses hat zur Folge, dass ein erhöhter beziehungsweise verringerter Signalhub in dem Zeitintervall erzeugt wird, in dem das betreffende Testsignal T1, T2 einen High-Pegel aufweist. Dieses soll nachfolgend näher erläutert werden. Dabei soll angenommen werden, dass in dem zu überwachenden System ein Druck von 100000 hPA (100 bar) herrscht und jeder der beiden Analogsensoren 2, 3 während des Normalbetriebs als Messsignal ein Stromsignal 6, 7 in Höhe von 10 mA ausgibt, welches mit dem gemessenen Druck korrespondiert.

Bei der Durchführung des Tests des ersten Sensormittels 20 des ersten Analogsensors 2 kommt es aufgrund des Widerstands R1 im Testpfad 26 des ersten Sensormittels 20 zu einer Widerstandserhöhung, so dass beispielsweise ein erstes Stromsignal 6 in Höhe von 8 mA ausgegeben wird. Daraus resultiert somit ein negativer Signalhub in Höhe von -2 mA im Vergleich zum ersten Stromsignal 6 in Höhe von 10 mA im Normalbetrieb. Umgekehrt kommt es bei der Durchführung des Tests des zweiten Sensormittels 30 zu einer Widerstandsreduzierung, so dass beispielsweise ein zweites Stromsignal 7 in Höhe von 12 mA ausgegeben wird. Daraus resultiert somit ein positiver Signalhub in Höhe von +2 mA im Vergleich zum zweiten Stromsignal 7 in Höhe von 10 mA während des Normalbetriebs.

Die entsprechenden Signalhübe werden von der ersten kombinierten Signalverarbeitungs- und Testsignalerzeugungseinrichtung 82 und der zweiten Signalverarbeitungseinrichtung 83 erfasst und verarbeitet und der Auswerteeinrichtung 86 der Sicherheitssteuerung 8 zur Verfügung gestellt. Die Auswerteeinrichtung 86 ist dazu ausgebildet, den Signalhub aus den empfangenen und von den beiden kombinierten Signalverarbeitungs- und Testsignalerzeugungseinrichtungen 82, 83 verarbeiteten Stromsignalen 6, 7, welche die Messsignale bilden und die entsprechenden Signalhübe enthalten, herauszurechnen.

Die Erwartungshaltung der Auswerteeinrichtung 86 der Sicherheitssteuerung 8 ist, dass sich die Stromsignale 6, 7 während der Durchführung des Tests des betreffenden Analogsensors 2, 3 in einem definierten Zeitintervall um einen definierten Wert ändern müssen, so dass daraus ein entsprechender Signalhub resultiert. Dadurch ist es möglich, die Messsignale, also die Stromsignale 6, 7 der beiden Analogsensoren 2, 3, zu plausibilisieren. Wie bereits erläutert, werden die beiden Analogsensoren 2, 3 zeitlich alternierend getestet. Diese alternierende Testung hat den Vorteil, dass insbesondere Kabelfehler, Querschlüsse, Fremdspannungseinspeisungen, Schlüsse gegenüber Signalmasse erfasst werden können.

Um eine Unterscheidung zwischen tatsächlichen Druckänderungen innerhalb des zu überwachenden Systems, die zu Widerstandsänderungen der Sensormittel 20, 30 führen, und einem Signalhub aufgrund einer gemeinsamen Fehlerursache (so genannter Common Cause Fehler), bei der es sich beispielsweise um elektromagnetische Störungen oder Störungen durch einen Widerstandstemperaturdrift handeln kann, zu ermöglichen, ist es vorteilhaft, in beiden Zweigen des Sensorsystems 1 unterschiedliche Verstärkungsfaktoren vorzusehen. Diese unterschiedlichen Verstärkungsfaktoren können vorteilhaft durch unterschiedliche k-Faktoren der beiden Wheatstone-Brücken 21, 31 realisiert sein. Unter einem k-Faktor wird eine Proportionalitätsgröße verstanden, welche den Zusammenhang zwischen der gemessenen mechanischen Verformung und der relativen Verformung des betreffenden Sensormittels 20, 30 repräsentiert. Dieses bedeutet mit anderen Worten, dass das Ausgangssignal der Wheatstone-Brücken 21, 31 umso stärker ist, desto größer der k-Faktor ist. Daraus ergibt sich, dass die Auswirkung auf den erfassbaren Signalhub für beide Analogsensoren 2, 3 und damit in beiden Kanälen des Sensorsystems 1 unterschiedlich ist und damit detektierbar ist. Ist die Abweichung gleich, liegt eine Prozesswertänderung, vorliegend also eine Druckänderung, vor. Werden unterschiedliche Änderungen erfasst, liegt demgegenüber ein Fehlerfall vor.

Das hier beschriebene Verfahren ermöglicht in vorteilhafter Weise eine sichere Auswertung der nicht-sicheren Sensormittel 20, 30 der beiden Analogsensoren 2, 3 und dadurch auch eine Überprüfung der Sicherheitsintegrität des Sensorsystems.

## Patentansprüche

1. Sensorsystem (1), umfassend
- einen ersten Analogsensor (2) mit zumindest einem ersten resistiven Sensormittel (20), welches zur Messung einer physikalischen Größe eingerichtet ist, und mit einer ersten Wheatstone-Brücke (21), welche das erste Sensormittel (20) umfasst und dazu ausgebildet ist, ein erstes analoges Spannungssignal (4) zu erzeugen, welches ein Messsignal des ersten Analogsensors (2) bildet oder aus dem das Messsignal des ersten Analogsensors (2) durch eine Messsignalwandlung erzeugbar ist, wobei das erste Sensormittel (20) an einen ersten Schaltpfad (24) angeschlossen ist, der einen Arbeitspfad (25) und einen Testpfad (26) umfasst, der parallel zum Arbeitspfad (25) geschaltet ist und gegenüber dem Arbeitspfad (25) veränderte Widerstandseigenschaften aufweist,
- einen zweiten Analogsensor (3) mit zumindest einem zweiten resistiven Sensormittel (30), welches zur Messung einer physikalischen Größe eingerichtet und mit einer zweiten Wheatstone-Brücke (31), welche das zweite Sensormittel (30) umfasst und dazu ausgebildet ist, ein zweites analoges Spannungssignal (5) zu erzeugen, welches ein Messsignal des zweiten Analogsensors (3) bildet oder aus dem das Messsignal des zweiten Analogsensors (3) durch eine Messsignalwandlung erzeugbar ist, wobei das zweite Sensormittel (30) an einen zweiten Schaltpfad (34) angeschlossen ist, der einen Arbeitspfad (35) und einen Testpfad (36) umfasst, der parallel zum Arbeitspfad (35) geschaltet ist, und gegenüber dem Arbeitspfad (35) veränderte Widerstandseigenschaften aufweist,
- eine Sicherheitssteuerung (8), die an die Analogsensoren (2, 3) angeschlossen ist, wobei die Sicherheitssteuerung (8) dazu ausgebildet ist,
a) die Messsignale des ersten Analogsensors (2) und des zweiten Analogsensors (3) zu empfangen und auszuwerten,
b) zum Testen des ersten Sensormittels (20) den Testpfad (26) des ersten Schaltpfads (24) zu aktivieren, ein erstes Testsignal (T1) zu erzeugen und einen Signalhub des Messsignals des ersten Analogsensors (2) zu erfassen,
c) zum Testen des zweiten Sensormittels (30) den Testpfad (36) des zweiten Schaltpfads (34) zu aktivieren, ein zweites Testsignal (T2) zu erzeugen und einen Signalhub des Messsignals des zweiten Analogsensors (3) zu erfassen, und
d) den Signalhub der Messsignale der Analogsensoren (2, 3) zu plausibilisieren.

2. Sensorsystem (1) nach Anspruch 1, **dadurch gekennzeichnet, dass** die Sicherheitssteuerung (8) dazu ausgebildet ist, während des Tests des ersten Sensormittels (20) den Arbeitspfad (25) des ersten Schaltpfads (24) zu deaktivieren.

3. Sensorsystem (1) nach einem der Ansprüche 1 oder 2, **dadurch gekennzeichnet, dass** die Sicherheitssteuerung (8) dazu ausgebildet ist, während des Tests des zweiten Sensormittels (30) den Arbeitspfad (35) des zweiten Schaltpfads (34) zu deaktivieren.

4. Sensorsystem (1) nach einem der Ansprüche 1 bis 3, **dadurch gekennzeichnet, dass** der Arbeitspfad (25) des ersten Sensormittels (20) einen Öffnerkontakt (27) und der Testpfad (26) einen Schließerkontakt (28) und einen elektrisch in Reihe dazu geschalteten Widerstand (R1) umfasst, so dass der Arbeitspfad (25) und der Testpfad (26) für das erste Sensormittel (20) unterschiedliche Widerstandseigenschaften aufweisen.

5. Sensorsystem (1) nach einem der Ansprüche 1 bis **4, dadurch gekennzeichnet, dass** der Arbeitspfad (35) des zweiten Sensormittels (30) einen Öffnerkontakt (37) und einen elektrisch in Reihe dazu geschalteten Widerstand (R2) umfasst und der Testpfad (36) einen Schließerkontakt (38) umfasst, so dass der Arbeitspfad (35) und der Testpfad (36) für das zweite Sensormittel (30) unterschiedliche Widerstandseigenschaften aufweisen.

6. Sensorsystem (1) nach einem der Ansprüche 1 bis 5, **dadurch gekennzeichnet, dass** die Sicherheitssteuerung (8) dazu ausgebildet ist, den ersten Analogsensor (2) und den zweiten Analogsensor (3) zeitlich alternierend zu testen.

7. Sensorsystem (1) nach einem der Ansprüche 1 bis 6, **dadurch gekennzeichnet, dass** die Sicherheitssteuerung (8) dazu ausgebildet ist, die Testsignale (T1, T2) als Rechteckpulse zu erzeugen.

8. Sensorsystem (1) nach einem der Ansprüche 1 bis 7, **dadurch gekennzeichnet, dass** die Sicherheitssteuerung (8) eine erste kombinierte Signalverarbeitungs- und Testsignalerzeugungseinrichtung (82), die dem ersten Analogsensor (2) zugeordnet ist, und/oder dass die Sicherheitssteuerung (8) eine zweite kombinierte Signalverarbeitungs- und Testsignalerzeugungseinrichtung (83), die dem zweiten Analogsensor (3) zugeordnet ist, umfasst.

9. Sensorsystem (1) nach einem der Ansprüche 1 bis 8, **dadurch gekennzeichnet, dass** die Analogsensoren (2, 3) derart ausgebildet sind, dass sie die Messsignale unterschiedlich stark verstärken.

10. Verfahren zur Überprüfung einer Sicherheitsintegrität eines Sensorsystems (1) nach einem der Ansprüche 1 bis 9, wobei
- zum Testen des ersten Sensormittels (20) der Testpfad (26) des ersten Schaltpfads (24) geschlossen wird, das erste Testsignal (T1) erzeugt wird und ein daraus resultierender Signalhub des Messsignals des ersten Analogsensors (2) erfasst wird,
- zum Testen des zweiten Sensormittels (30) der Testpfad (36) des zweiten Schaltpfads (34) geschlossen wird, das zweite Testsignal (T2) erzeugt wird und ein daraus resultierender Signalhub des Messsignals des zweiten Analogsensors (3) erfasst wird, und
- der Signalhub des Messsignals des ersten Analogsensors (2) und der Signalhub des Messsignals des zweiten Analogsensors (3) von der Sicherheitssteuerung (8) plausibilisiert werden.
